# EUROPEAN PATENT APPLICATION

(11) **EP 2 403 026 A2**
(43) Date of publication of application: **04.01.2012**
(21) Application number: 11169259.6
(22) Date of filing: 09.06.2011
(51) Int. Cl.: H01L 35/08

(54) **Connection structure of elements and connection method**

(30) Priority: 30.06.2010 JP 2010148401
(71) Applicant: Kabushiki Kaisha Toyota Jidoshokki, Kariya-shi, Aichi 448-8671 (JP)
(72) Inventor: Morisaku, Naoto, Kariya-shi, Aichi 448-8671 (JP); Akiyama, Hirokuni, Kariya-shi, Aichi 448-8671 (JP)
(74) Representative: TBK

(57) **Abstract**

A connection structure for elements includes a first plate having an electrode layer formed on one surface of the first plate, an element connected to the electrode layer at one surface of the element and a second plate connected to the other surface of the element.

A connection method for the above elements comprises the steps of: disposing the element on upper surface of the electrode layer of the first plate through solder and the second plate on upper surface of the element through conductive paste and heating the solder and the conductive paste simultaneously for melting the solder and calcining the conductive paste.

## Description

### BACKGROUND OF THE INVENTION

The present invention relates to a connection structure of elements and a connection method of the same.

Japanese Application Publication S58-169993 discloses a method for connecting elements to a printed substrate.

Japanese Application Publication 2001-274177 discloses a method of manufacturing a semiconductor device having a semiconductor element held at the opposite surfaces thereof through soldering flux. The semiconductor elements are connected to a lead member through first soldering flux and then the lead member to which the semiconductor elements are connected is inverted. Then, a conductive member is connected to the lower surface of the inverted semiconductor element, i.e. the surface to which no lead member is connected through the first soldering flux, through second soldering flux whose melting temperature is lower than that of the first soldering flux.

Japanese Application Publication S62-226676 discloses a manufacturing method of a thermoelectric generation device having a thermoelectric generating element and a radiator plate connected together. An electrode pattern of copper paste is printed on the surface of the radiator plate and the thermoelectric generating element is connected at one surface thereof to the radiator plate through the copper paste. A cover plate is disposed on the other surface of the thermoelectric generating element through a thermally-resistant gasket. The radiator plate and the cover plate have formed therethrough holes for fasteners. By inserting fasteners through the holes and fastening them, the cover plate, the radiator plate and the thermoelectric generating elements are connected in a manner that the cover plate and the radiator plate hold therebetween the thermoelectric generating elements.

In the connection method according to Japanese Application Publication S58-169993 in which the elements are connected to the opposite surfaces of the printed substrate, there is a fear that the parts on the upper and the lower surfaces are electrically connected by any soldering flux melted and dripping from the upper surface to the lower surface. In the connection method according to Japanese Application Publication 2001-274177 in which the connection by soldering is performed in two separate batches, the heating treatment needs to be performed twice. In case of connecting elements by conductive paste, it is difficult for the connection method to adapt to variations of dimensions between the connected parts. In case of connecting in a manner that the cover plate and the radiator plate have therebetween the thermoelectric generating elements as disclosed in Japanese Application Publication S62-226676, it is necessary to increase the processing accuracy of the connections for reducing the tolerances between the thermoelectric generating elements and the radiating plate and between the thermoelectric generating elements and the upper plate.

The present invention is directed to providing a connection method and a connection structure of elements which allow connection of base plates to the opposite surfaces of the elements at one time without causing electrical bridging and offer adaptability to variations of the elements.

### SUMMARY OF THE INVENTION

A connection structure for elements includes a first plate having an electrode layer formed on one surface of the first plate, an element connected to the electrode layer at one surface of the element and a second plate connected to the other surface of the element.

A connection method for the above elements comprises the steps of: disposing the element on upper surface of the electrode layer of the first plate through solder and the second plate on upper surface of the element through conductive paste and heating the solder and the conductive paste simultaneously for melting the solder and calcining the conductive paste.

Other aspects and advantages of the invention will become apparent from the following description, taken in conconnection with the accompanying drawings, illustrating by way of example the principles of the invention.

### BRIEF DESCRIPTION OF THE DRAWINGS

The features of the present invention that are believed to be novel are set forth with particularity in the appended claims. The invention together with objects and advantages thereof, may best be understood by reference to the following description of the presently preferred embodiments together with the accompanying drawings in which:
FIG. 1 is a schematic cross sectional view explaining a connection structure and a connection method of a Peltier element 5 according to a first embodiment of the present invention; and
FIG. 2 is a schematic cross sectional view explaining a connection structure and a connection method for the Peltier element 5 according to a second embodiment of the present invention.

### DETAILED DESCRIPTION OF THE PREFERRED EMBODIMENTS

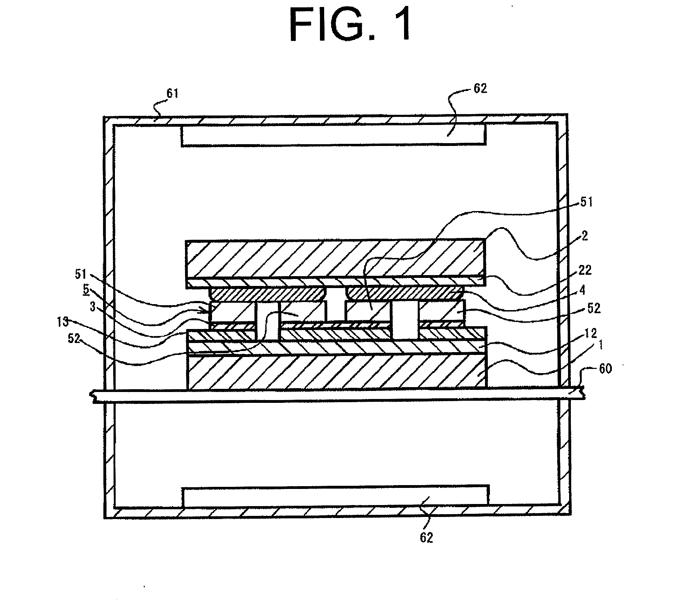

The following will describe the first embodiment of the present invention with reference to FIG. 1.

For the sake of expedience, some of the parts are drawn larger than their actual sizes.

Firstly, the connection of a Peltier element 5 will be described. As shown in FIG 1, the Peltier elements 5, namely P-type Peltier element 51 and N-type Peltier element 52, are interposed between a first plate 1 and a second plate 2 each made of a metal with other several layers. Specifically, a first insulating layer 12 is formed on the entire upper surface of the first plate 1. An electrode layer 13 is formed on the upper surface of the first insulating layer 12 by printed wiring. A second insulating layer 22 is formed on the entire lower surface of the second plate 2. In the first embodiment, the first and the second plates 1, 2 are made of aluminum and the first and the second insulating layers 12, 22 are made of a plastic insulating film including a thermally-conductive filler.

In the first embodiment, a solder paste 3, the composition of which is Sn-Ag-Cu and which is blended by lead-free solder and flux, is coated on the upper surface of the electrode layer 13. A conductive paste 4 made of a mixture of silver particle and a binder is coated on the lower surface of the second insulating layer 22.

In the first embodiment, the melting temperature and the deteriorating temperature of the solder paste 3 are 220°C and about 350°C, respectively. The deteriorating temperature of solder as used herein means the temperature when solder begins to degenerate. Specifically, when the solder is of a solder paste, the deteriorating temperature of the solder means the temperature when the solder begins to denature, i.e., when flux of solder paste begins to carbonize or when it begins to fly apart. The melting temperature range of the solder means a range between the melting temperature of the solder and the deteriorating temperature of the solder paste. Since the calcining temperature range of the conductive paste 4 is between 150°C and 250°C, the conductive paste 4 can be calcined in the temperature range corresponding to the melting temperature range of the solder by selecting an appropriate kind of conductive paste.

The Peltier element 5 (P-type Peltier element 51 and N-type Peltier element 52) as an element is disposed on the upper surface of the electrode layer 13 on the first plate 1 through the solder paste 3. The second insulating layer 22 is disposed on the other surface of the Peltier element 5 (or the upper surface of the Peltier element 5 in FIG. 1) through the conductive paste 4. In other words, the peltier element 5 is disposed between the second insulating layer 22 and the electrode layer 13 that face each other and are provided between the first and the second plates 1, 2, respectively. The electrode layer 13 and the Peltier element 5 are connected by the solder paste 3 and the second insulating layer 22 and the Peltier element 5 are connected by the conductive paste 4, respectively.

The P-type Peltier elements 51 and the N-type Peltier elements 52 are arranged alternately. The conductive paste 4 is coated between the lower surface of the second insulating layer 22 and the upper surface of the Peltier element 5 so as to connect a pair of the P-type Peltier element 51 and its adjacent N-type Peltier element 52. The solder paste 3 is coated between the upper surface of the electrode layer 13 and the lower surface of the Peltier element 5 so as to connect a pair of the N-type Peltier element 52 and its adjacent P-type Peltier element 51. The pair of Peltier elements connected by the conductive paste 4 and the pair of Peltier elements connected by the solder paste 3 are disposed in a staggered arrangement with an overlap corresponding to a length of one Peltier element in horizontal direction in FIG. 1. Specifically, when the P-type Peltier element 51, the N-type Peltier element 52, the P-type Peltier element 51, the N-type Peltier element 52 are connected electrically in this order as shown in FIG. 1, the conductive paste 4 forms a connection from the P-type Peltier element 51 to the N-type Peltier element 52 and the solder paste 3 forms a connection from the N-type Peltier element 52 to the P-type Peltier element 51.

The following will describe a connection method of the Peltier element 5 with reference to FIG. 1. As the first step, the Peltier element 5 is disposed on the upper surface of the electrode layer 13 of the first plate 1 through the solder paste 3. Next, the second plate 2 having on the lower surface thereof the second insulating layer 22 is disposed on the upper surface of the Peltier element 5 through the conductive paste 4. The first, second plates 1, 2 and the Peltier element 5 thus disposed are placed on a belt conveyer 60 and transferred into a reflow oven 61 by the belt conveyer 60. The reflow oven 61 has therein on the upper and lower wall surfaces thereof heaters 62. In the heating step following the step of disposing the Peltier element 5, the solder paste 3 and the conductive paste 4 are heated simultaneously so that melting of the solder paste 3 and calcination of the conductive paste 4 occur. In the first embodiment, the heating temperature by the heaters 62 is set at 220°C that corresponds to the melting temperature of the solder paste 3 (220°C).

The following will describe the operation according to the first embodiment. In the disposition step, the second plate 2 is disposed on the upper surface of the Peltier element 5 through the conductive paste 4. The first plate 1 is disposed on the lower surface of the Peltier element 5 through the solder paste 3. In the heating step following the disposition, the solder paste 3 and the conductive paste 4 are heated simultaneously by the heaters 62 in the reflow oven 61.

If the Peltier element 5 and the second plate 2 are connected through the solder paste 3 and the distance between the second insulating layer 22 and the electrode layer 13 is small, e.g., about 1 mm, there is a fear of short circuit may occur between the second insulating layer 22 and the electrode layer 13 by the solder paste 3 melted and dripping from the second insulating layer 22 to the electrode layer 13. However, the Peltier element 5 and the second plate 2 are connected through the conductive paste 4 in the first embodiment and, therefore, the fear of short circuit therebetween by dripping of the melted solder paste 3 can be prevented.

Since the conductive paste 4 is calcined in the connection, it is difficult for the conductive paste 4 to adapt to variations of the connection in vertical direction as compared with the solder paste 3. In case of connecting the opposite sides of the Peltier element 5 by the conductive paste 4, the processing accuracy of the connection needs to be improved. In the first embodiment wherein the upper surface of the Peltier element 5 is connected by the conductive paste 4 and the lower surface thereof is connected by the solder paste 3, the tolerance of the connection in vertical direction can be adapted by melting the solder paste 3. Specifically, even if there is variation in the height of the Peltier element 5 due to any burr of the Peltier element 5 formed during cutting and other variations resulting from the manufacturing process, it is easy to connect the Peltier element 5 and each of the first and the second plates 1, 2.

Since the solder paste 3 and the conductive paste 4 are simultaneously heated in the heating step, it is not necessary to heat twice or more for melting the solder paste 3 and calcining the conductive paste 4. In other words, it is possible to connect the second plate 2 to the upper surface of the Peltier element 5 and the first plate 1 to the lower surface of the Peltier element 5 by one time of heating. The thermal stress acting on the Peltier element 5 can be reduced as compared with the case of heating the Peltier element 5 twice or more.

The first insulating layer 12 is formed between the first plate 1 and the electrode layer 13 and the second insulating layer 22 is formed on the lower surface of the second plate 2. Therefore, when the first and the second plates 1, 2 are made of conductive metal, the Peltier element 5 can be insulated from each of the first and the second plates 1, 2 by the first and the second insulating layers 12, 22, respectively.

If the calcining temperature range of the conductive paste 4 is higher than the melting temperature range of solder and also the solder paste 3 is heated to the calcining temperature range of conductive paste 4, the solder paste 3 begins to melt before the heating temperature reaches the calcining temperature range of the conductive paste 4, so that solder paste 3 is deteriorated. However, in the first embodiment, the conductive paste 4 can calcine in the temperature range corresponding to the melting temperature range of the solder paste 3. Therefore, when the solder paste 3 is heated to the melting temperature range of the solder paste 3 by the heaters 62, the melting of the solder paste 3 and the calcination of the conductive paste 4 occur at the same time. Since it is possible to connect the Peltier element 5 and each of the first and the second plates 1, 2 simultaneously by one time of heating, the manufacturing of a semiconductor device is facilitated.

When the P-type Peltier element 51, the N-type Peltier element 52, the P-type Peltier element 51, the N-type Peltier element 52 are connected electrically in this order, the endothermic reaction occurs at the connection where an electric current flows from the N-type Peltier element 52 to the P-type Peltier element 51 and the exothermic reaction occurs at the connection where an electric current flows from the P-type Peltier element 51 to the N-type Peltier element 52. In other words, the exothermic reaction occurs on the surface of the Peltier element 5 connected by the conductive paste 4 and the endothermic reaction occurs on the other surface of the Peltier element 5 connected by the solder paste 3. Since the endothermic reaction occurs on one surface of the Peltier element 5 and the exothermic reaction occurs on the other surface thereof, the Peltier element 5 is generally used with the base plates connected to the opposite surfaces thereof. Thus, the connection method according to the first embodiment is suitably used for the connection wherein the first and the second plates 1, 2 are connected to the opposite surfaces of the Peltier element 5, respectively.

When a solder sheet is used instead of the solder paste 3, the solder sheet needs to be cut to a shape corresponding to that of the surface of the Peltier element 5. The use of the solder paste 3 as in the first embodiment is advantageous in that it can be applied to the electrode layer 13 by coating.

The solder paste 3 and the conductive paste 4 are heated by the heater 62 in the reflow oven 61, so that the entire connection structure including the first and the second plates 1, 2 and the Peltier element 5 that are set in the disposition step can be heated with ease.

The first embodiment offers the following advantageous effects.
(1) The second plate 2 is disposed on the upper surface of the Peltier element 5 through the conductive paste 4 in the disposition step. The first plate 1 is disposed on the lower surface of the Peltier element 5 through the solder paste 3. In the heating step following the disposition step, the solder paste 3 and the conductive paste 4 are heated simultaneously by the heaters 62 in the reflow oven 61. Therefore, the first and the second plates 1, 2 can be connected to the opposite surfaces of the Peltier element 5, respectively, at the same time without inviting a short circuit between the first and the second plates 1, 2 due to dripping of melted solder paste and also the tolerance of the connection in vertical direction can be adapted easily.
(2) The first insulating layer 12 is formed between the first plate 1 and the electrode layer 13. The second insulating layer 22 is formed on the lower surface of the second plate 2. Therefore, when the first and the second plates 1, 2 are made of a conductive material, the insulation between the Peltier element 5 and the respective first and the second plates 1, 2 can be accomplished by the first and the second insulating layers, respectively.
(3) Since the conductive paste 4 can be calcined in the temperature range corresponding to the melting temperature range of the solder paste 3, the solder paste 3 can be melted and the conductive paste 4 calcined at the same time when the solder paste 3 is heated to a temperature in its melting temperature range. Therefore, it is possible to connect the Peltier element 5 to the respective first and the second plates 1, 2 by one time of heating.
(4) In a case where a Peltier element 5 is used as an element of a semiconductor device, the connection method according to the present invention of connecting the first and the second plates 1, 2 to the opposite surfaces of the Peltier element 5, respectively, is suitable.
(5) The use of the solder paste 3 as a solder that can be coated on the electrode layer 13 helps to facilitate the manufacturing process.
(6) Heating the solder paste 3 and the conductive paste 4 by the heaters 62 in the reflow oven 61 is advantageous in that the entire connection structure including the first and the second plates 1, 2 and the Peltier element 5 that are disposed in the disposition step can be heated simultaneously.

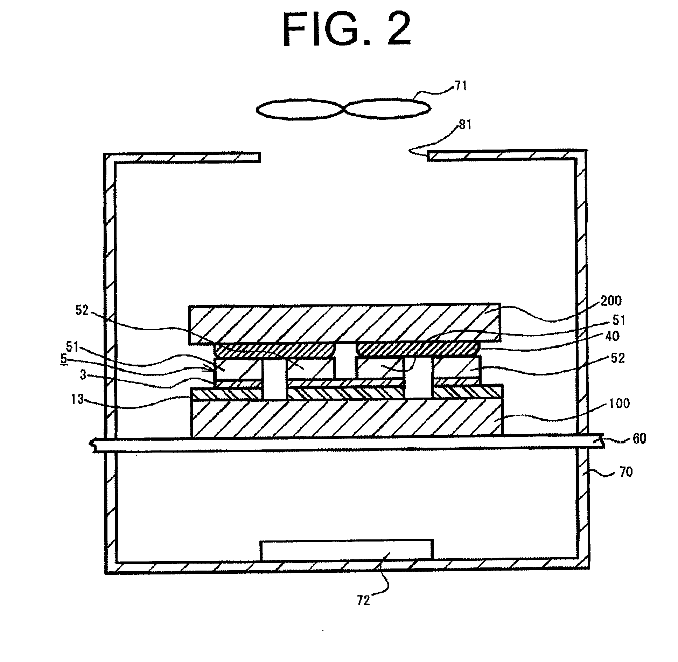

The following will describe the connection structure of the Peltier element 5 according to the second embodiment with reference to FIG 2. The connection structure according to the second embodiment shown in FIG. 2 differs from the counterpart according to the first embodiment in that the first and the second insulating layers 12, 22 in the connection structure of the first embodiment are dispensed with and the heating step is modified. The following description will use the same reference numerals for the common elements or components in the first and the second embodiments and the description of such common elements or components will be omitted.

As shown in FIG 2, the electrode layer 13 is formed on upper surface of the first plate 100 and the Peltier element 5 is disposed on the upper surface of the electrode layer 13 through the solder paste 3. The second plate 200 is disposed on the upper surface of the Peltier element 5 through the conductive paste 40 that is Ag paste whose calcining temperature range is set lower than that of the conductive paste 4 according to the first embodiment. The solder paste 3 of the second embodiment is made of the same material as that of the first embodiment. The melting and deteriorating temperatures of the solder paste 3 are about 220°C and 350°C, respectively.

In the second embodiment, the calcining temperature range of the conductive paste 40 is adjusted to a range between 100°C and 200°C by the choice of an appropriate material of the binder for the conductive paste 40 and this calcining temperature range differs from the melting temperature range of the solder paste 3 (or the range of temperature between 220°C when the solder paste 3 begins to melt and 350°C when the solder begins to deteriorate).

The first and the second plates 100, 200 are made of an insulating material. The calcining temperature range of the conductive paste 40 is lower than the melting temperature range of the solder paste 3. The thermal conductivity of the conductive paste 40 is higher than that of the solder paste 3.

The following will describe the connection method of the Peltier element 5 according to the second embodiment.

An opening 81 through which air can flow is formed in the top of the reflow oven 70, i.e., on the upper side of the Peltier element 5 on the belt conveyer 60 that has the conductive paste 40 applied thereto. The heater 72 is installed in the bottom of the reflow oven 70, i.e., on the side of the Peltier element 5 on the belt conveyer 60 that has the solder paste 3 coated to the Peltier element 5. A fan 71 is arranged above the top of the reflow oven 70 so as to face the opening 81 for cooling the interior of the reflow oven 70.

In the heating, the Peltier element 5 is heated by the heater 72 from the solder paste 3 side of the Peltier element 5 in the reflow oven 70. Therefore, the solder paste 3 is heated to 220°C, while the conductive paste 40 is heated to a temperature between 100°C and 200°C due to the location of the heater 72. Heating the solder paste 3 and the conductive paste 40 by the heater 72 from the solder paste 3 side of the Peltier element 5, the conductive paste 40 is heated to a temperature that is lower than that of the solder paste 3. That is, the conductive paste 40 is adjusted to be heated so that its temperature falls within the calcining temperature range for the conductive paste 40. On the other hand, the Peltier element 5 is cooled by the fan 71 from the conductive paste 40 side of the Peltier element 5 in the reflow oven 70. Thus, the temperatures of the solder paste 3 and the conductive paste 40 are adjusted by the combined use of the heater 72 and the fan 71.

The following will describe the operation of the connection structure according to the second embodiment.

The first and the second plates 100, 200 which are made of an insulating material are insulated from the Peltier element 5 without using any insulators corresponding to the first and the second insulating layers 12, 22 according to the first embodiment.

The calcining temperature range of the conductive paste 40 is lower than the melting temperature range of the solder paste 3. In the heating, the heater 72 and the fan 71 are operated so as to adjust the respective heating temperatures of the conductive paste 40 and the solder paste 3. In other words, the combined use of the heater 72 and the fan 71 heats the conductive paste 40 to a temperature within the calcining temperature range of the conductive paste 40 and the solder paste 3 to a temperature within the melting temperature range of the solder paste 3. Thus, if the calcining temperature range of the conductive paste 40 differs from the melting temperature range of the solder paste 3, the Peltier element 5 can be connected to the first and the second plates 100, 200 at one time.

The heater 72 installed in the bottom of the reflow oven 70 heats the interior of the reflow oven 70 from the solder paste 3 side of the Peltier element 5 mounted to the belt conveyer 60. In the heating according to the second embodiment, the solder paste 3 and the conductive paste 40 are heated from the first plate 100 side of the Peltier element 5.

When the melting temperature range of the solder paste 3 is higher than the calcining temperature range of the conductive paste 40 (or when the calcining temperature range of the conductive paste 40 is lower than the melting temperature range of the solder paste 3), the solder paste 3 is heated much more than the conductive paste 40 by heating from the first plate 100 side of the Peltier element 5. Thus, the temperatures of the conductive paste 40 and the solder paste 3 when heated by the heater 72 are different from each other. Heating temperature can be adjusted so that the solder paste 3 is heated to a temperature within the melting temperature range of the solder paste 3 and that the conductive paste 40 is heated to a temperature within the calcining temperature range of the conductive paste 40.

The fan 71 that is arranged above the reflow oven 70, i.e., on the conductive paste 40 side of the Peltier element 5 mounted to the belt conveyer 60 cools the interior of the reflow oven 70. In the heating according to the second embodiment, cooling is performed from the second plate 200 side of the Peltier element 5.

When the melting temperature range of the solder paste 3 is higher than the calcining temperature range of the conductive paste 40 (or when the calcining temperature range of the conductive paste 40 is lower than the melting temperature range of the solder paste 3), therefore, it is easy to adjust the temperature of the conductive paste 40 lower than that of the solder paste 3 by cooling from the second plate 200 side of the Peltier element 5. The heating temperature can be adjusted so that the solder paste 3 is heated to a temperature within the melting temperature range of the solder paste 3 and that the conductive paste 40 is heated to a temperature within the calcining temperature range of the conductive paste 40.

When the P-type Peltier element 51, the N-type Peltier element 52, the P-type Peltier element 51, the N-type Peltier element 52 are connected electrically in this order, the endothermic reaction occurs at the connection where an electric current flows from the N-type Peltier element 52 to the P-type Peltier element 51 and the exothermic reaction occurs at the connection where an electric current flows from the P-type Peltier element 51 to the N-type Peltier element 52. In other words, the exothermic reaction occurs on the surface of the Peltier element 5 connected by the conductive paste 40 and the endothermic reaction occurs on the other surface of the Peltier element 5 connected by the solder paste 3. The amount of heat generation of the Peltier element 5 is larger than the amount of heat absorption of the Peltier element 5 by the amount of power consumption of the Peltier element 5.

In this case, the thermal conductivity of the material connected to the surface where the exothermic reaction occurs should be higher than that of the material connected to the surface where the endothermic reaction occurs. If the heat caused by the exothermic reaction can be transferred more easily than that caused by the endothermic reaction, the amount of heat transfer per unit time can be increased.

In the second embodiment, the thermal conductivity of the conductive paste 40 is higher than that of the solder paste 3. When the electric current direction remains the same and the P-type Peltier element 51, the N-type Peltier element 52, the P-type Peltier element 51, the N-type Peltier element 52 are connected electrically in this order, the connection between the P-type Peltier element 51 and the N-type Peltier element 52, i.e., the surface of the Peltier element 5 connected through the conductive paste 40 (or the surface where the exothermic reaction occurs) has a thermal conductivity that is higher than that of the connection between the N-type Peltier element 52 and the P-type Peltier element 51, i.e., the surface of the Peltier element 5 connected through the solder paste 3 (or the surface where the endothermic reaction occurs). Therefore, the amount of heat transfer per unit time can be increased.

The connection structure according to the second embodiment offers the following advantageous effects in addition to the advantageous effects (1) through (6) according to the first embodiment.
(7) Since the first and the second plates 100, 200 are made of an insulating material, the insulation between the Peltier element 5 and the respective first and the second plates 100, 200 can be accomplished without using insulators corresponding to the first and the second insulating layers 12, 22 according to the first embodiment.
(8) The heating is adjusted by the combined use of the heater 72 and the fan 71 so that the temperatures of the conductive paste 40 and the solder paste 3 are at respective different temperatures. Therefore, if the calcining temperature range of the conductive paste 40 differs from the melting temperature range of the solder paste 3, the conductive paste 40 and the solder paste 3 can be heated to respective desired temperatures in the second embodiment and the first and the second plates 100, 200 and the Peltier element 5 can be connected at one time.
(9) The heater 72 that is installed in the reflow oven 70 on the solder paste 3 side of the Peltier element 5 mounted to the belt conveyer 60 heats the solder paste 3 more than it heats the conductive paste 40. The heating can be adjusted so that the solder paste 3 is heated to a temperature within its melting temperature range and that the conductive paste 40 is heated to a temperature within its calcining temperature range.
(10) The fan 71 that is arranged on the conductive paste 40 side of the Peltier element 5 mounted to the belt conveyer 60 cools the conductive paste 40 more than it cools the solder paste 3. The cooling by the fan 71 can be adjusted so that the solder paste 3 is heated to a temperature within its melting temperature range and that the conductive paste 40 is heated to a temperature within its calcining temperature range.
(11) The thermal conductivity of the conductive paste 40 is higher than that of the solder paste 3. When the conductive paste 40 is disposed on the surface of the Peltier element 5 where the exothermic reaction occurs and the solder paste 3 is disposed on the other surface of the Peltier element 5 where the endothermic reaction occurs, the amount of heat transfer per unit time can be increased.

The present invention is not limited to the above-described embodiments. The present invention may be practiced in various ways within the scope of the present invention, as exemplified below.

In the first embodiment, the material of the first and the second plates 1, 2 is not limited to aluminum. They may be made of copper or a stainless steel. The first and the second plates 1, 2 made of aluminum are inexpensive and lightweight. The first and the second plates 1, 2 made of copper can improve their thermal conductivity as compared with a case where they are made of aluminum. The first and the second plates 1, 2 made of a stainless steel can improve their corrosion resistance as compared with a case where they are made of aluminum or copper.

In the second embodiment, the second plate 200 may not necessarily be made of an insulating material, but it may be made of a conductive material. When the second plate 200 is made of a conductive material, an insulating layer needs to be formed between the electrode layer 13 and the second plate 200. When the second plate 200 is made of an insulating material, plastics, aluminum or aluminum nitride may be used as the insulating material.

In the first embodiment, although the first and the second insulating layers 12, 22 are made of a plastic insulating film including a thermally-conductive filler, they may be formed by sputtering aluminum nitride.

In the first and the second embodiments, the heating may not be performed in the reflow oven 61, 70. Radiation or a hot plate may be used for the heating instead of the heater 62, 72. In the first embodiment, the heaters 62 may not be provided in the top and the bottom of the reflow oven 61, respectively, but a single heater may be provided in either the top or the bottom of the reflow oven 61.

In the first and the second embodiments, the solder is not limited to a solder paste such as 3. The solder may be of a solder sheet type.

In the first and the second embodiments, the element for connection is not limited to the Peltier element 5. The element may be a thermoelectric generating element or a power element such as a diode.

In the first and the second embodiments, the material of the conductive paste 4, 40 may be chosen appropriately. The conductive paste 4, 40 may be of a type that contains copper, silver or gold. The conductive paste 4, 40 containing copper is advantageously inexpensive. The conductive paste 4, 40 containing silver or gold has a high electrical conductivity and a low calcining temperature, so that any thermal stress applied to the Peltier element 5 can be decreased.

In the first embodiment, the first and the second insulating layers 12, 22 need not necessarily be formed on entire surfaces of the first and the second plates 1, 2. The first insulating layer 12 may be formed only in the area corresponding to the electrode layer 13 and similarly, the second insulating layer 22 may be formed only in the area corresponding to the conductive paste 4.

In the first and the second embodiments, the electrode layers may be formed between the conductive paste 4 and the second insulating layer 22 and between the conductive paste 40 and the second plate 200, respectively.

In the second embodiment, the fan 71 may be dispensed with. Heating temperatures of the solder paste 3 and the conductive paste 40 may be adjusted by heating the interior of the reflow oven 70 from the solder paste 3 side of the Peltier element 5 by the heater 72 provided in the bottom of the reflow oven 70. In the second embodiment, the heaters 62 may be provided in the top and the bottom of the reflow oven 70, respectively, and the fan 71 may cool the interior of the reflow oven 70 from the conductive paste 40 side of the Peltier element 5 for adjusting the heating temperatures of the solder paste 3 and the conductive paste 40.

In the second embodiment, the cooling from one side of the Peltier element 5 need not necessarily be performed by the fan 71. Metal with a large heat capacity may be disposed in the reflow overn 70 on the side of the Peltier element 5 that needs to be cooled. The metal with large heat capacity may be disposed on the upper surface of the second plate 200. The metal with large heat capacity may be a stainless steel or aluminum.

In the second embodiment, the calcining temperature range of the conductive paste 40 may not necessarily be lower than that of the solder paste 3. The calcining temperature range of the conductive paste 40 may be higher than that of the solder paste 3. In this case, for adjusting the heating temperatures of the conductive paste 40 and the solder paste 3, the heating is performed so as to heat from the conductive paste 40 side of the Peltier element 5 or so as to cool from the solder paste 3 side of the Peltier element 5.

In the second embodiment, the thermal conductivity of the conductive paste 40 may not necessarily be higher than that of the solder paste 3, but the thermal conductivity of the conductive paste 40 may be lower than or substantially the same as that of the solder paste 3. When the thermal conductivity of the conductive paste 40 is lower than that of the solder paste 3, the electric current flowing direction may be adjusted so that the endothermic reaction occurs on the surface of the Peltier element 5 where the conductive paste 40 is coated and that the exothermic reaction occurs on the other surface of the Peltier element 5 where the solder paste 3 is coated for increasing the amount of heat transfer per unit time.

A connection structure for elements includes a first plate having an electrode layer formed on one surface of the first plate, an element connected to the electrode layer at one surface of the element and a second plate connected to the other surface of the element.

A connection method for the above elements comprises the steps of: disposing the element on upper surface of the electrode layer of the first plate through solder and the second plate on upper surface of the element through conductive paste and heating the solder and the conductive paste simultaneously for melting the solder and calcining the conductive paste.

## Claims

1. A connection method for elements, wherein a connection structure for the elements including:
a first plate (1, 100) having an electrode layer (13) formed on one surface of the first plate (1, 100);
an element (5) connected to the electrode layer (13) at one surface of the element (5); and
a second plate (2, 200) connected to the other surface of the element (5), **characterized in that** the connection method for the elements comprising the steps of:
disposing the element (5) on upper surface of the electrode layer (13) of the first plate (1, 100) through solder (3) and the second plate (2, 200) on upper surface of the element (5) through conductive paste (4, 40); and
heating the solder (3) and the conductive paste (4, 40) simultaneously for melting the solder (3) and calcining the conductive paste (4, 40).

2. The connection method for the elements according to claim 1, **characterized in that** the connection structure of the elements further including:
a first insulating layer (12) formed between the first plate (1) and the electrode layer (13); and
a second insulating layer (22) formed on lower surface of the second plate (2).

3. The connection method for the elements according to any one of claims 1 and 2, **characterized in that** while the solder (3) and the conductive paste (4) are heated, the conductive paste (4) can be calcined in temperature range corresponding to melting temperature range of the solder (3).

4. The connection method for elements for the elements according to any one of claims 1 and 2, **characterized in that** while the solder (3) and the conductive paste (4) are heated, heating temperature of the solder (3) differs from that of the conductive paste (4) each other.

5. The connection method for elements for the elements according to claim 4, **characterized in that** while the solder (3) and the conductive paste (4) are heated, the heating is done firstly with either one of the solder (3) and the conductive paste (4) that has a higher value of temperature range between melting temperature range of the solder (3) and calcining temperature range of the conductive paste (4).

6. The connection method for elements for the elements according to any one of claims 4 and 5, **characterized in that** while the solder (3) and the conductive paste (4) are heated, the cooling is done firstly with either one of the solder (3) and the conductive paste (4) that has a lower value of temperature range between melting temperature range of the solder paste (3) and calcining temperature range of the conductive paste (4).

7. The connection method for elements for the elements according to claim 1, **characterized in that** the element of the connection structure is a Peltier element (5).

8. A connection structure for elements comprising:
a first plate (1, 100) having an electrode layer (13) formed on one surface of the first plate (1, 100);
an element (5) connected to the electrode layer (13) at one surface of the element (5);
a second plate (2, 200) connected to the other surface of the element (5);
solder (5) connecting the electrode layer (13) and the element (5); and
conductive paste (4, 40) connecting the second plate (2, 200) and the element (5).

9. The connection structure for the elements according to claim 8, **characterized in that** the connection structure for the elements further comprising:
a first insulating layer (12) formed between the first plate (1) and the electrode layer (13); and
a second insulating layer (22) formed between the second plate (2) and the conductive paste (4).

10. The connection structure for the elements according to any one of claims 8 and 9, **characterized in that** the conductive paste (4, 40) can be calcined in temperature range corresponding to melting temperature range of the solder (3).

11. The connection structure for the elements according to any one of claims 8 through 10, **characterized in that** the element (5) is a Peltier element (5).
